# EUROPÄISCHE PATENTANMELDUNG

(11) **EP 4 737 912 A1**
(43) Veröffentlichungstag der Anmeldung: **06.05.2026**
(21) Anmeldenummer: 25212024.1
(22) Anmeldetag: 29.10.2025
(51) Int. Cl.: G01R 1/04, B33Y 10/00, B33Y 70/10, G01R 31/16

(54) **ELEKTRODE, KABELMESSVORRICHTUNG UND KABELMESSWAGEN**

(30) Priorität: 04.11.2024 AT 1592024
(71) Anmelder: BAUR GmbH, 6832 Sulz (AT)
(72) Erfinder: Breuß, Bernhard, 6713 Ludesch (AT); Lahann, Norman, 6800 Feldkirch (AT); Hähner, Lars, 6850 Dornbirn (AT)
(74) Vertreter: Torggler & Hofmann Patentanwälte - Rankweil

(57) **Zusammenfassung**

Eine Elektrode (2), welche mittels eines additiven Fertigungsverfahrens, bevorzugt aus einem Kunststoff, hergestellt ist. Kabelmessvorrichtung sowie Kabelmesswagen mit derselben.

## Beschreibung

Die vorliegende Erfindung betrifft eine Elektrode für eine Kabelmessvorrichtung, eine Kabelmessvorrichtung, einen Kabelmesswagen und ein Verfahren zum Durchführen einer Kabelmessung.

Bekannt sind grundsätzlich Kabelmessungen, wie Teilentladungsmessungen und Verlustfaktormessungen, die an Hoch- und Mittelspannungskabeln durchgeführt werden, um zu prüfen, ob Instandsetzungsarbeiten an den Kabeln durchzuführen sind.

Mit der WO 2021/198146 A1 wurde eine Schaltungsanordnung bekannt, womit beispielsweise eine Teilentladungsmessung im laufenden Betrieb, das heißt "online" während das Kabel unter Betriebsspannung steht, durchgeführt werden kann. Die Durchführung der Kabelmessung ist dadurch stark vereinfacht.

Aufgrund der Größe und der Masse von Messgeräten für Teilentladungsmessungen und Verlustfaktormessungen von Hoch- und Mittelspannungskabeln ist eine weitere Vereinfachung solcher Messungen aber durchaus wünschenswert, weil der Transport der Messgeräte zum Ort der Kabelmessung - zumindest in der letzten Teilstrecke von Hand - aufwändig ist.

Die Aufgabe ist es daher, Kabelmessungen, insbesondere Teilentladungsmessungen, zu vereinfachen.

Die Aufgabe wird durch eine Elektrode für eine Kabelmessvorrichtung gemäß Anspruch 1 gelöst, nämlich indem die Elektrode mittels eines additiven Fertigungsverfahrens, bevorzugt aus einem Kunststoff, hergestellt ist.

Dadurch, dass ein additives Fertigungsverfahren verwendet wird, kann die Elektrode in ihrer geometrischen Gestaltung praktisch frei konstruiert werden. Eine solche Freiformelektrode erlaubt es, deren Geometrie rein auf Basis des gewünschten elektrischen Feldes zu optimieren, ohne Rücksicht auf die erheblichen fertigungstechnischen Limitierungen beispielsweise von urformenden oder spanabtragenden Fertigungsverfahren legen zu müssen.

Eine Schwierigkeit bei der Konstruktion von Elektroden für die Kabelmessungen liegt nämlich darin, dass in der Kabelmessvorrichtung teilweise spitze Geometrien unvermeidbar sind, die bei hohen Spannungen zu Feldstärkespitzen im Umfeld der spitzen Geometrien führen. An solchen Feldstärkespitzen treten dann potenziell Entladungen durch die Luft auf, die als Teilentladungen bezeichnet werden und das Messsignal der eigentlich zu detektierenden Teilentladung am zu vermessenden Kabel maskieren.

Mit der vorliegenden Offenbarung kann auf Basis der zu erwarteten Spannungen und der gewünschten Baugröße der Kabelmessvorrichtung beispielsweise mittels einer an und für sich bekannten Simulation ermittelt werden, wo Feldstärkespitzen auftreten. Natürlich kann dies auch anhand von Messungen an einem Prototyp der Elektrode oder der Kabelmessvorrichtung ermittelt werden. Bevorzugt können Simulationen und Messungen oder Tests an Prototypen auch kombiniert werden.

An jenen Stellen, an denen Feldstärkespitzen oder Teilentladungen in der Kabelmessvorrichtung auftreten, kann dann die Elektrode - beispielsweise durch Abrunden und Heranführen der Geometrie an die Stelle der Feldstärkespitzen - so verändert werden, dass die Feldstärkespitzen nicht mehr auftreten. Letztlich kann so durch eine adaptierte, meist rundere und kompaktere, Form der Elektroden ein verkleinerter Bauraum der Elektrode und folglich auch der Kabelmessvorrichtung erzielt werden.

Auch die Masse der Elektrode wird sich durch die kleinere Bauform verkleinern.

Zu erwähnen ist, dass der verkleinerte Bauraum und die verkleinerte Masse in Bezug auf jene Ausführung zu sehen ist, die mit anderen Fertigungsverfahren in technisch vernünftigem Umfang und mit technisch vernünftigem Aufwand zu erzielen ist.

Der Aufwand für den Transport der Kabelmessvorrichtung zum Ort der Kabelmessung wird durch die kleinere Bauform und die geringere Masse entscheidend verringert.

Überraschend ist, dass eine additiv gefertigte Elektrode überhaupt die Eignung haben kann, in einer Kabelmessvorrichtung eingesetzt zu werden, weil zunächst zu erwarten ist, dass die internen Strukturen im Werkstoff, die beim schrittweisen Aufbau der Elektrode entstehen, für die Führung des elektrischen Stroms schädlich sind. Es hat sich aber herausgestellt, dass dieses Problem bei den bei Hoch- und Mittelspannungskabeln auftretenden Frequenzen nicht auftritt.

In bevorzugten Ausführungsformen wird die Elektrode aus einem Kunststoff additiv gefertigt.

Besonders überraschend war, dass Elektroden mit der Eignung in einer Kabelmessvorrichtung eingesetzt zu werden trotz der hohen auftretenden Spannungen zuverlässig aus Kunststoff hergestellt werden können.

Zu erwähnen ist, dass die Elektrode nicht unbedingt vollständig durch ein additives Herstellungsverfahren oder vollständig aus Kunststoff hergestellt werden müssen. Die Herstellung von Teilen der Elektrode mit nicht additiven Fertigungsverfahren, beispielsweise mit spanabtragenden oder urformenden Verfahren, sind natürlich möglich insoweit sich der oben erwähnte technische Effekt der Erfindung einstellt.

In bevorzugten Ausführungsformen wird aber die gesamte Elektrode durch ein additives Herstellungsverfahren und/oder aus Kunststoff (gegebenenfalls mit Zusätzen und/oder Füllstoffen) hergestellt.

Der Kunststoff muss also nicht vollständig rein sein, was technisch ohnehin unmöglich wäre. Beispielsweise können Zusätze und Füllstoffe verwendet werden, um physikalische Eigenschaften des Kunststoffs und der Elektrode zu beeinflussen. Zusätze und Füllstoffe für Kunststoffe sind in der Kunststofftechnik in erheblicher Anzahl an und für sich bekannt.

Geschützt ist außerdem eine Kabelmessvorrichtung mit zumindest einer Elektrode, bevorzugt genau zwei Elektroden, nach der in dieser Offenbarung beschriebenen Art.

In besonders bevorzugten Ausführungsformen liegt die Kabelmessvorrichtung in einem Zustand vor, in dem die zumindest eine Elektrode eine oder mehrere wie auch immer geartete Messimpedanzen (resistiv, kapazitiv, induktiv) umgibt.

In einem weiteren Aspekt der Erfindung wird die Aufgabe durch einen Kabelmesswagen gemäß Anspruch 13 gelöst, nämlich einen Kabelmesswagen mit einer Kabelmessvorrichtung, bevorzugt nach der vorbeschriebenen Offenbarung, wobei die Kabelmessvorrichtung zum Durchführen einer Kabelmessung, bevorzugt einer Teilentladungsmessung und/oder einer Verlustfaktormessung, in einem im Kabelmesswagen montierten Zustand ausgebildet ist.

Besonders bevorzugt kann die im Kabelmesswagen montierte Kabelmessvorrichtung zum gleichzeitigen Durchführen einer Teilentladungsmessung und einer Verlustfaktormessung im im Kabelmesswagen montierten Zustand ausgebildet sein.

Die Kabelmessvorrichtung soll demnach so ausgebildet und im Kabelmesswagen montiert sein, dass die Kabelmessung stattfinden kann, ohne die Kabelmessvorrichtung demontiert werden muss. Das heißt, das zu vermessende Kabel soll mittelbar oder unmittelbar an die im Kabelmesswagen montierte Kabelmessvorrichtung angeschlossen werden können und die sohin die Kabelmessung durchführbar sein.

In besonders bevorzugten Ausführungsformen der Erfindung beinhaltet die im Kabelmesswagen montierte Kabelmessvorrichtung zumindest eine Elektrode, die gemäß der vorliegenden Offenbarung mit einem additiven Fertigungsverfahren hergestellt ist. Durch die additiv gefertigte Elektrode kann die Kabelmessvorrichtung so klein gestaltet werden, dass sie im Kabelmesswagen besonders leicht Platz findet.

Beim Kabelmesswagen kann es sich bevorzugt um ein Kraftfahrzeug der Transporterklasse handeln.

In einem weiteren Aspekt der Erfindung wird die Aufgabe durch ein Verfahren zum Durchführen einer Kabelmessung gemäß Anspruch 14 gelöst, nämlich durch ein Verfahren zum Durchführen einer Kabelmessung, insbesondere einer Teilentladungsmessung und/oder einer Verlustfaktormessung, wobei das zu prüfende Kabel mittelbar oder unmittelbar an eine Kabelmessvorrichtung angeschlossen wird und die Kabelmessung durchgeführt wird, während die Kabelmessvorrichtung in einem Kabelmesswagen montiert ist.

Das zu prüfende Kabel kann unmittelbar an die Kabelmessvorrichtung angeschlossen werden. Bevorzugt kann aber ein mittelbares Anschließen, besonders bevorzugt mittels einer Schaltungsanordnung gemäß der WO 2021/198146 A1, geschehen.

Bei einer Teilentladungsmessung wird gemessen, ob unerwünschte Teilentladungen, das heißt unerwünschtes Abfließen von Ladung im Regelfall ohne Durchschlagen, entlang des zu vermessenden Kabels geschehen.

Bei modernen Teilentladungsmessungen kann gegebenenfalls, das heißt optional, auch der Ort der Teilentladung und/oder eine Frequenzcharakteristik der Teilentladung festgestellt werden.

Bei einer Verlustfaktormessung wird das Verhältnis von Wirkleistung zu Blindleistung bestimmt, wobei die Wirkleistung und die Blindleistung beispielsweise aus Spannungs- und Strommessungen berechnet werden.

Bei ganz besonders bevorzugten Ausführungsbeispielen eines Kabelmesswagens gemäß der vorliegenden Offenbarung ist die Kabelmessvorrichtung zum gleichzeitigen Durchführen einer Teilentladungsmessung und einer Verlustfaktormessung eingerichtet.

Geschützt ist außerdem die Verwendung einer Elektrode gemäß der vorliegenden Offenbarung und/oder einer Kabelmessvorrichtung gemäß der vorliegenden Offenbarung und/oder eines Kabelmesswagens gemäß der vorliegenden Offenbarung bei einem Verfahren zum Durchführen einer Kabelmessung gemäß der vorliegenden Offenbarung.

Vorteilhafte Weiterbildungen der vorliegenden Offenbarung sind in den abhängigen Ansprüchen definiert.

Der Kunststoff, aus dem die Elektrode hergestellt ist, kann ein Polyamid beinhalten oder daraus bestehen. Polyamid ist für eine Elektrode für Kabelmessungen an Hoch- und Mittelspannungskabeln aufgrund der ausgezeichneten mechanischen und thermischen Widerstandsfähigkeit sehr gut geeignet.

Polyamid 12 kann ein besonders bevorzugter Kunststoff für die Elektrode gemäß der vorliegenden Offenbarung sein, weil es Typen von Polyamid 12 gibt, die gute Leitfähigkeit aufweisen und/oder dafür modifiziert sind.

Besonders bevorzugt ist es außerdem, den Kunststoff mit Füllstoffen zu modifizieren, um die Leitfähigkeit und/oder die mechanischen Eigenschaften und/oder die thermische Widerstandsfähigkeit der Elektrode zu beeinflussen.

Besonders bevorzugt sind dabei Ausführungsformen mit Kohlenstofffasern als Füllstoff, weil sie extrem gute mechanische Eigenschaften aufweisen und aufgrund der Kohlenstoffatome außerdem eine exzellente Leitfähigkeit aufweisen.

Das additive Fertigungsverfahren kann bevorzugt selektives Lasersintern sein. Beim selektiven Lasersintern werden auf ein Werkstück aufgetragenes Pulver mittels eines Lasers geschmolzen, sodass sich das aufgetragene Pulver mit dem Werkstück stoffschlüssig verbindet und schließlich die gewünschte Elektrodenform entsteht.

Selektives Lasersintern kann gegenüber anderen additiven Fertigungsverfahren bevorzugt sein, weil es auch bei komplexen Geometrien eine einteilige Fertigung der Elektroden erlaubt, ohne dass Stützstrukturen erforderlich sind. Bei den Elektroden der vorliegenden Offenbarung ist dies sehr vorteilhaft, weil Stützstrukturen, die nach der Fertigung entfernt werden müssen, Grate und dergleichen an der Elektrode hinterlassen können. Solche Grate sind bei Elektroden sehr nachteilig, weil sich an spitzen Strukturen, wie erwähnt, Feldstärkespitzen einstellen können, die wie erwähnt ja gerade vermieden werden sollen.

Insbesondere können mit selektivem Lasersintern auch gefüllte und ungefüllte Kunststoffe, wie beispielsweise das erwähnte Kohlenstofffaser-gefüllte Polyamid 12, verarbeitet werden.

Die Elektrode kann bevorzugt eine Grundform einer Schale mit einem Boden aufweisen und im Boden kann zumindest eine Öffnung vorgesehen sein. Diese Grundform hat sich bei der Entwicklung als sehr vorteilhaft herausgestellt, weil im Inneren der Schalenform Messelemente der Kabelmessvorrichtung gut Platz finden, Teilentladungen effizient abgefangen werden können und gleichzeitig eine gewisse Zugänglichkeit für die Montage, beispielsweise der Messelemente, oder für den Gasaustausch mit dem Außenraum gegeben ist.

In besonders bevorzugten Ausführungsformen werden, wie erwähnt, genau zwei Elektroden verwendet. Dabei kann es ganz besonders bevorzugt sein, dass diese von einer schalenförmigen Grundform sind, wobei die Schalenformen mit ihrer jeweiligen offenen Seite zueinander weisen.

Dabei kann es weiterhin bevorzugt sein, wenn die beiden Elektroden beabstandet sind.

Zu erwähnen ist, dass sich die offenen Seiten der Schalenform von den bodenseitigen Öffnungen unterscheiden.

In einer Wandung der Schale kann zumindest eine laterale Ausnehmung, bevorzugt genau drei laterale Ausnehmungen, vorhanden sein, durch welche zumindest eine laterale Ausnehmung jeweils ein Anschluss führbar ist, welcher die Elektrode durchsetzt.

Der jeweilige Anschluss kann beispielsweise eine Buchse oder ein Kabel beinhalten.

Besonders vorteilhaft können Ausführungsformen mit zwei Elektroden sein, die jeweils die Grundform einer Schale haben, deren offene Seiten einander zugewandt sind, wobei beide Elektroden zumindest eine laterale Ausnehmung haben, die einander so gegenüberliegen, dass eine Öffnung in den Innenraum der Elektroden für den jeweiligen Anschluss gebildet wird.

Bevorzugt können so genau drei Öffnungen in den Innenraum bestehen.

Wie erwähnt, kann im Boden der Schalenform zumindest eine Öffnung vorhanden sein.

Bevorzugt kann es genau eine Öffnung sein, in welcher bevorzugt ein Träger für Bauelemente der Kabelmessvorrichtung angeordnet oder anordenbar ist. Die Verwendung eines solchen Trägers ermöglicht eine besonders einfache Montage der Bauelemente im Inneren der Elektrode oder der Elektroden.

Bevorzugt kann es bodenseitig in der Schalenform eine Vielzahl von Öffnungen geben, welche einen Gasaustausch zwischen einem Innenraum der Elektrode und einem Außenraum der Elektrode erlauben. Dies kann den Vorteil haben, dass ein Gasaustausch ermöglicht wird, sodass durch die hohen Spannungen im Innenraum der Elektrode oder der Elektroden erhitztes Gas aus dem Innenraum austreten kann.

Das Gas wird in aller Regel Luft sein. Ausführungsformen mit anderen Gasen sind aber prinzipiell denkbar.

In bevorzugten Ausführungsformen mit zwei Elektroden, welche die Grundform einer Schale haben, wobei bodenseitig zumindest eine Öffnung vorhanden ist, kann bevorzugt
- eine erste der Elektroden genau eine bodenseitige Öffnung aufweist, in welcher bevorzugt ein Träger für Bauelemente der Kabelmessvorrichtung angeordnet oder anordenbar ist, und/oder
- eine zweite der Elektroden eine Vielzahl von Öffnungen aufweist, welche einen Gasaustausch zwischen einem Innenraum der Elektrode und einem Außenraum der Elektrode erlauben.

Die erste Elektrode kann bevorzugt eine untere Elektrode sein und/oder die zweite Elektrode kann bevorzugt eine obere Elektrode sein.

Die Kabelmessvorrichtung kann bevorzugt zum Durchführen einer Teilentladungsmessung eingerichtet sein.

Die Kabelmessvorrichtung kann bevorzugt zum Durchführen einer Verlustfaktormessung eingerichtet sein, wobei eine Verlustfaktormessung in der Fachsprache auch als Tangen Delta-Messung bezeichnet wird.

In besonders bevorzugten Ausführungsformen kann es vorgesehen sein, dass die Kabelmessvorrichtung zum gleichzeitigen Durchführen einer Teilentladungsmessung und einer Verlustfaktormessung eingerichtet ist. Dafür müssen die notwendigen Messanschlüsse an der Kabelmessvorrichtung vorhanden sein (beispielsweise sowohl eine Strom- als auch eine Spannungsmessung) und es müssen an der Messtechnik die hard- und softwaretechnischen Voraussetzungen gegeben sein.

Im Innenraum der Elektrode oder der Elektroden kann bevorzugt zumindest eines der folgenden vorgesehen sein:
- ein erster Anschluss für ein zu vermessendes Kabel und bevorzugt eine Kontaktelektrode zum leitenden Verbinden des ersten Anschlusses mit einer Elektrode gemäß der vorliegenden Offenbarung
- ein zweiter Anschluss für einen Ausgang eines Spannungsgenerators und/oder ein Strostärkemmessgerät
- ein dritter Anschluss für ein erstes Messgerät, bevorzugt ein Spannungsmessgerät
- zumindest ein Widerstandselement zum leitenden Verbinden des ersten Anschlusses mit dem zweiten Anschluss
- eine Filterinduktivität

Bevorzugt kann die zumindest eine Elektrode oder eine durch mehrere Elektroden gebildete Elektrodenanordnung, bevorzugt über den Träger gemäß der vorliegenden Offenbarung, über zumindest einen Kondensator mit einem zweiten Messgerät, bevorzugt ein Ladungsmessgerät, leitend verbunden sein.

Es kann ein, vorzugsweise geerdetes oder erdbares, Gehäuse vorhanden sein, worin die Elektrode oder Elektroden gemäß der vorliegenden Offenbarung angeordnet ist beziehungsweise sind.

Es kann bevorzugt eine Frequenzweiche vorgesehen sein, über welche das zu vermessende Kabel mit der Kabelmessvorrichtung verbindbar ist.

Bevorzugt kann das zu vermessende Kabel über die Frequenzweiche an die Kabelmessvorrichtung angeschlossen sein.

Für die parallele Durchführung von Teilentladungsmessungen und Verlustfaktormessungen kann die erwähnte Frequenzweiche besonders vorteilhaft sein. Für diese unterschiedlichen Messungen werden nämlich bevorzugt verschiedene Frequenzbereiche messtechnisch erfasst. Die Frequenzweiche bietet eine einfache und effiziente Möglichkeit die gewünschten Frequenzbereiche der jeweiligen Auswerteelektronik zuzuführen.

Weitere Vorteile und Einzelheiten der vorliegenden Offenbarung ergeben sich aus den Figuren und der dazugehörigen Beschreibung der Figuren. Es zeigen:
- Fig. 1a und 1b: schematisch ein Ausführungsbeispiel einer Elektrodenanordnung,
- Fig. 2a bis 2c: schematisch ein Ausführungsbeispiel einer Kabelmessvorrichtung,
- Fig. 3: schematisch eine Detaildarstellung des Ausführungsbeispiels auf Fig. 2a bis 2c,
- Fig. 4: schematisch ein Beispiel für eine Messanordnung für eine Teilentladungsmessung und eine Verlustfaktormessung,
- Fig. 5: schematisch einen Kabelmesswagen sowie
- Fig. 6: ein weiteres Ausführungsbeispiel einer Elektrodenanordnung.

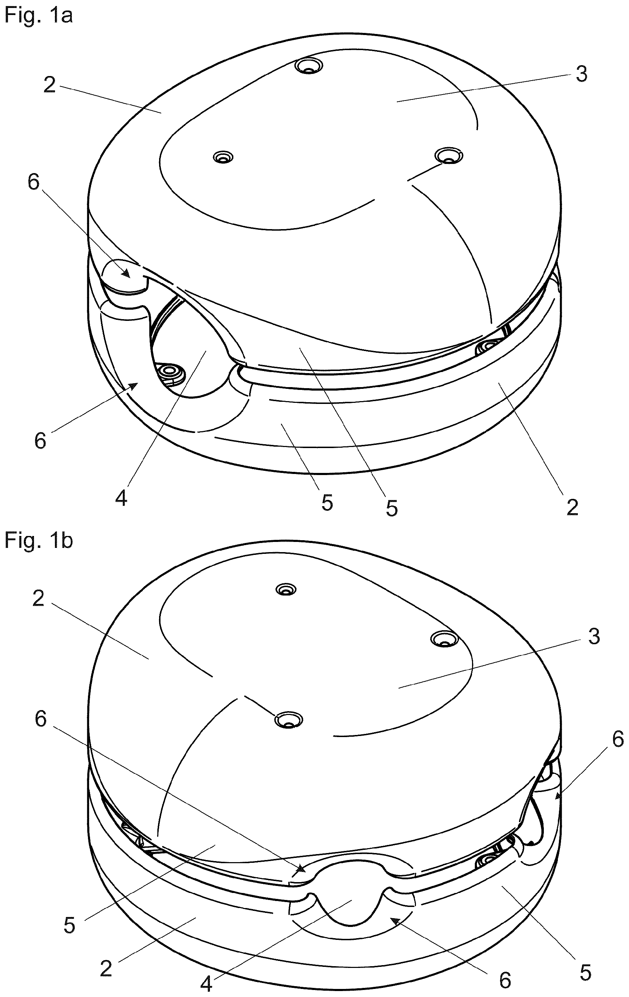

Fig. 1a und 1b zeigen schematisch eine Elektrodenanordnung mit zwei Elektroden 2 aus zwei verschiedenen Perspektiven.

In diesem Ausführungsbeispiel sind die Elektroden 2 durch selektives Lasersintern aus mit Kohlenstofffasern gefülltem Polyamid 12 gefertigt.

Wie ersichtlich ist, ist es dadurch einfach möglich, die Elektroden 2 mit Wölbungen und Krümmungen zu versehen, sodass spitze Strukturen vermieden werden können, die zu Feldüberhöhungen des elektrischen Feldes führen würden. Gleichzeitig ist im Innenraum der Elektrodenanordnung aus Fig. 1a und 1b genügend Platz, um darin Messelemente für vorgesehenen Messungen unterzubringen.

Die Elektroden 2 haben jeweils die Grundform einer Schale mit einem Boden 3 aufweisen, wobei die Schalenformen mit ihren offenen Seiten zueinander weisen. Der Boden 3 der in Fig. 1a und 1b unteren Elektrode 2 ist in den Figuren verdeckt.

Wie ersichtlich ist, kommt es dadurch bei der in Fig. 1a und 1b oberen Elektrode 2 zu einer invertierten Anordnung, wobei der Boden 3 der Schalenform dieser Elektrode auf der Oberseite der Elektrodenanordnung sichtbar ist.

In Wandungen 5 der Schalenformen der Elektroden 2 sind laterale Ausnehmungen 6 vorhanden, nämlich in diesem Ausführungsbeispiel genau drei laterale Ausnehmungen, durch welche jeweils ein Anschluss führbar ist, welcher die Elektroden 2 durchsetzt. Genau drei laterale Ausnehmungen 6 sind im Sinne der vorliegenden Offenbarung vorteilhaft, weil die besonders bevorzugt vorgesehenen Messungen genau drei Anschlüsse erfordern. Natürlich können Fachleute die Anzahl der lateralen Ausnehmungen anpassen, falls eine andere Anzahl von Anschlüssen für die vorgesehenen Messungen erforderlich oder bevorzugt sind.

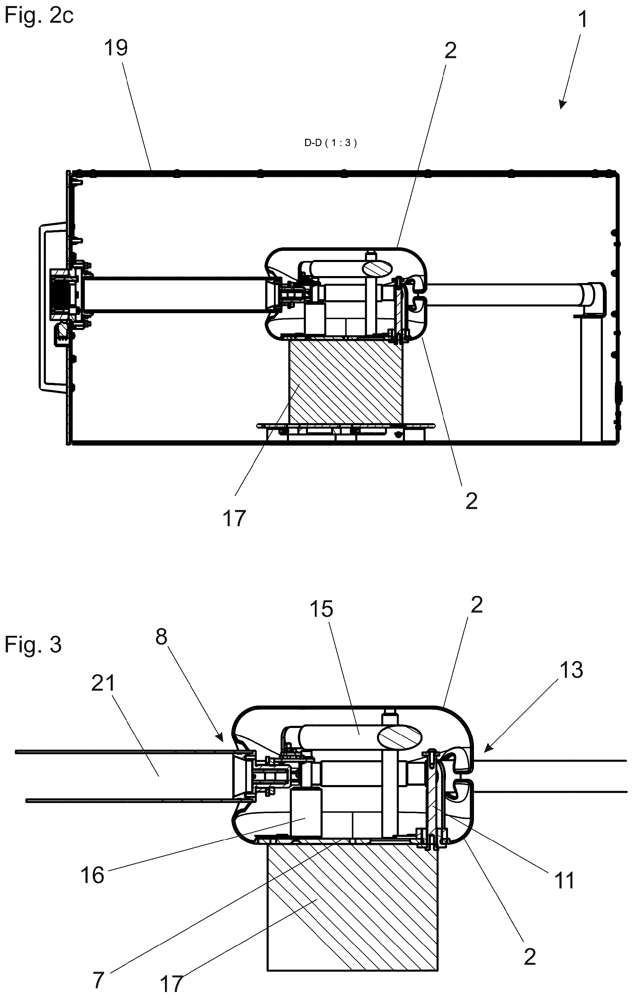

Im Boden 3 der in Fig. 1a und 1b unteren Elektrode 2 ist (genau) eine Öffnung 4 vorgesehen. In dieser Öffnung 4 kann ein Träger 7 für Bauelemente der Kabelmessvorrichtung 1 angeordnet werden, wofür auf Fig. 2c und 3 zu verweisen ist. Die Verwendung eines solchen Trägers 7 ermöglicht eine besonders einfache Montage der Bauelemente im Inneren der Elektroden 2.

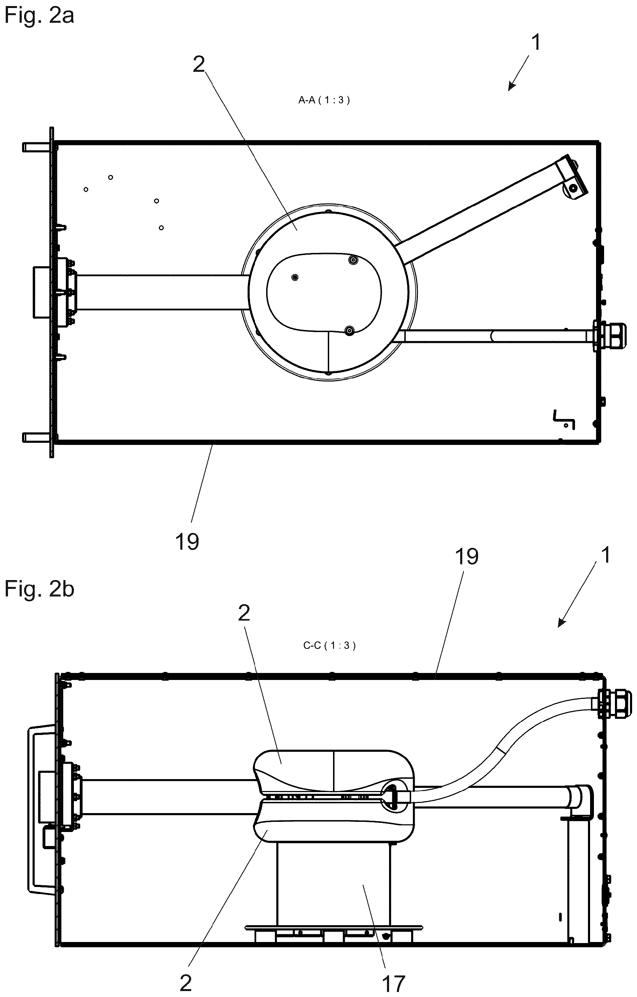

In den Fig. 2a bis 2c ist schematisch eine Kabelmessvorrichtung 1 dargestellt, nämlich in einer Ansicht von oben mit geöffnetem Gehäuse 19 (Fig. 2a), in einer Seitenansicht mit geöffnetem Gehäuse 19 (Fig. 2b) sowie in einer Schnittdarstellung.

Die Kabelmessvorrichtung 1 gemäß den Fig. 2a bis 2c weist in diesem Ausführungsbeispiel die Elektrodenanordnung mit den zwei Elektroden 2 aus Fig. 1a und 1b auf, welche in einem geerdeten oder erdbaren Gehäuse 19 angeordnet ist.

Hinzuweisen ist darauf, dass weitere externe Bausteine vorhanden sein können, wie beispielsweise Messgeräte oder Spannungsgeneratoren.

Mehrere Anschlüsse führen ins Innere der Elektrodenanordnung, welches über einen rein schematisch dargestellten Kondensator 17 mit dem Gehäuse 19 verbunden ist. Der Kondensator 17 kann auch als Teilentladungskoppler bezeichnet werden, welcher an sich im Stand der Technik bekannt ist.

Das Innenleben der Elektrodenanordnung ist in Verbindung mit Fig. 3 näher beschrieben.

Zunächst ist zu erwähnen, dass die Bauelemente im Innenraum der Elektrodenanordnung über einen Träger 7 gelagert sind, welcher in der Öffnung 4 im Boden 3 der in Fig. 3 unteren Elektrode 2 angeordnet ist.

Die in Fig. 3 unten angeordnete Elektrode 2 ist jene, die auch in Fig. 1a und 1b unten angeordnet ist.

Im Innenraum der Elektroden 2 sind in diesem Ausführungsbeispiel die folgenden Bauelemente angeordnet:
- ein erster Anschluss 8 für ein zu vermessendes Kabel 9 und bevorzugt eine Kontaktelektrode zum leitenden Verbinden des ersten Anschlusses mit einer der Elektroden 2
- ein zweiter Anschluss 11 für einen Ausgang eines Spannungsgenerators 12 und ein Strommessgerät (beispielsweise integriert in den Spannungsgenerator)
- ein dritter Anschluss 13 für ein erstes Messgerät 14, bevorzugt ein Spannungsmessgerät
- zumindest ein Widerstandselement 15 zum leitenden Verbinden des ersten Anschlusses 8 mit dem zweiten Anschluss 11,
- eine Filterinduktivität 16

Zu erwähnen ist, dass das zu vermessendes Kabel 9 unmittelbar oder mittelbar, beispielsweise mit einem Anschlusskabel 21, mit dem ersten Anschluss 8 verbunden werden kann.

Wie bereits in Verbindung mit Fig. 2c erörtert, ist die Elektrodenanordnung über den Träger 7 und weiter über den Kondensator 17 mit dem zweiten Messgerät 18, bevorzugt ein Ladungsmessgerät, leitend verbindbar.

Die hier vorgestellte Ausgestaltung der Kabelmessvorrichtung 1 ist ein Beispiel für eine Ausgestaltung, wobei die Kabelmessvorrichtung 1 zum gleichzeitigen Durchführen einer Teilentladungsmessung und einer Verlustfaktormessung in der Lage ist.

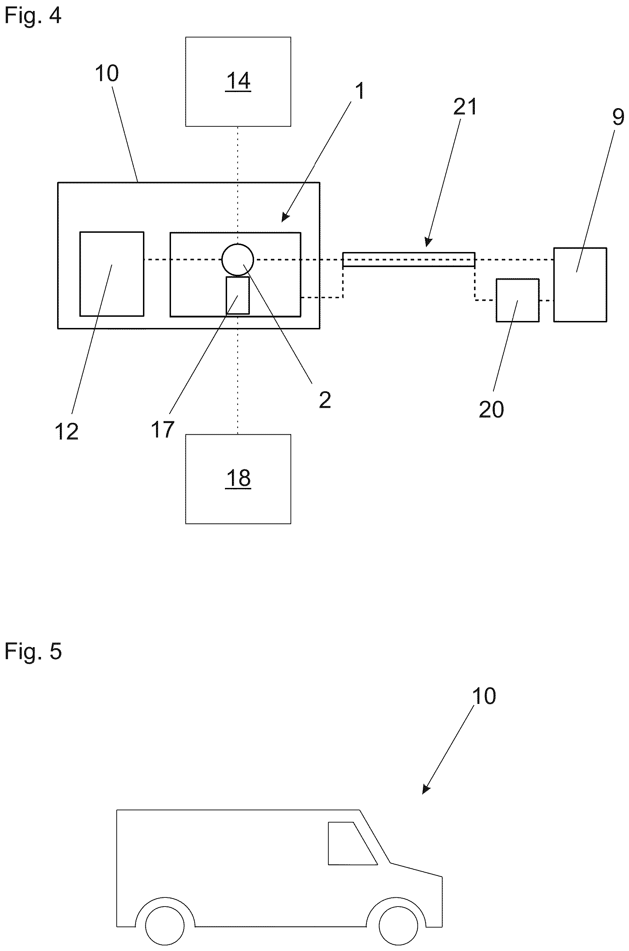

Fig. 4 zeigt eine Prinzipdarstellung einer Messanordnung, welche dazu eingerichtet ist, mit der Kabelmessvorrichtung 1 gleichzeitig eine Teilentladungsmessung und eine Verlustfaktormessung durchzuführen.

Das Messsystem, hier bevorzugt in Form eines Kabelmesswagens 10, verfügt über die schematisch dargestellte Kabelmessvorrichtung 1, einen Spannungsgenerator 12 sowie das erste Messgerät 14 und das zweite Messgerät 18.

Zu erwähnen ist, dass das erste Messgerät 14 und das zweite Messgerät 15 hier als extern in Bezug auf den Kabelmesswagen 10 dargestellt ist. In besonders bevorzugten Ausführungsformen sind das erste Messgerät 14 und/oder das zweite Messgerät 18 aber Teil des Kabelmesswagens 10 und in dessen Inneren angeordnet.

Das zu vermessende Kabel 9 (Prüfling) ist über eine Frequenzweiche 20 mit einem Leiter und der Isolation eines Anschlusskabels 21 verbunden. Weiters ist der Leiter des Anschlusskabels 21 mit dem ersten Anschluss 8 der Kabelmessvorrichtung 1 und die Isolation des Anschlusskabels 21 mit dem Gehäuse 19 geerdet.

In dieser Konfiguration kann in an sich bekannter Weise die Teilentladungsmessung und die Verlustfaktormessung durchgeführt werden. Gemäß der vorliegenden Offenbarung kann dies gleichzeitig geschehen.

Ein Beispiel für einen Kabelmesswagen 10 ist schematisch in Fig. 5 dargestellt, hier als ein Fahrzeug der Transporterklasse. Beispielsweise im Ladebereich des Kabelmesswagens 10 kann die Kabelmessvorrichtung 1 gemäß der vorliegenden Offenbarung angeordnet sein.

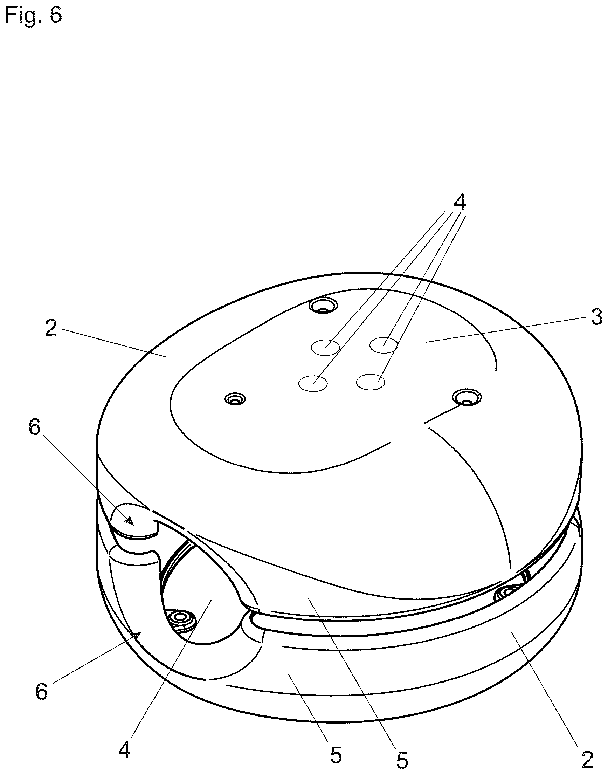

Fig. 6 zeigt schematisch ein Ausführungsbeispiel einer Elektrodenanordnung mit zwei Elektroden 2. Dieses Ausführungsbeispiel 2 ist weitgehend analog zu jenem aus den Fig. 1a und 1b.

Im Unterschied zur Ausführung aus Fig. 1a und 1b sind aber im Boden 3 der invertierten Schalenform der in Fig. 3 oberen Elektrode 2 mehrere schematisch dargestellte Öffnungen 4 vorhanden, die einen Gasaustausch zwischen einem Innenraum der Elektrodenanordnung und einem Außenraum der Elektrodenanordnung erlauben. Dies kann den Vorteil haben, dass ein Gasaustausch ermöglicht wird, sodass durch die hohen Spannungen im Innenraum der Elektrode 2 oder der Elektroden 2 erhitztes Gas aus dem Innenraum austreten kann.

Eine Vielzahl weiterer Ausführungsbeispiele ist denkbar. Immer wenn eine Messanordnung vor Teilentladungen geschützt werden soll, können per additivem Fertigungsverfahren gefertigte Elektroden 2 verwendet werden und eine relativ platzsparende Anordnung der entsprechenden Messelemente kann erzielt werden.

### L e g e n d e zu den Hinweisziffern:

- 1: Kabelmessvorrichtung
- 2: Elektrode
- 3: Boden
- 4: Öffnung
- 5: Wandung
- 6: laterale Ausnehmung
- 7: Träger
- 8: erster Anschluss
- 9: zu vermessendes Kabel
- 10: Kabelmesswagen
- 11: zweiter Anschluss
- 12: Spannungsgenerator
- 13: dritter Anschluss
- 14: erstes Messgerät
- 15: Widerstandselement
- 16: Filterinduktivität
- 17: Kondensator
- 18: zweites Messgerät
- 19: Gehäuse
- 20: Frequenzweiche
- 21: Anschlusskabel

## Patentansprüche

1. Elektrode für eine Kabelmessvorrichtung (1), **dadurch gekennzeichnet, dass** die Elektrode (2) mittels eines additiven Fertigungsverfahrens, bevorzugt aus einem Kunststoff, hergestellt ist.

2. Elektrode nach Anspruch 1, wobei der Kunststoff, aus dem die Elektrode (2) hergestellt ist,
- ein Polyamid, bevorzugt ein Polyamid 12, beinhaltet oder daraus besteht, und/oder
- einen Füllstoff, bevorzugt in Form einer Kohlenstofffaser, aufweist.

3. Elektrode nach einem der vorhergehenden Ansprüche, wobei das additive Fertigungsverfahren selektives Lasersintern ist.

4. Elektrode nach einem der vorhergehenden Ansprüche, wobei die Elektrode (2) eine Grundform einer Schale mit einem Boden (3) aufweist und bevorzugt im Boden (3) zumindest eine Öffnung (4) vorgesehen ist.

5. Elektrode nach Anspruch 4, wobei in einer Wandung (5) der Schale zumindest eine laterale Ausnehmung (6), bevorzugt genau drei laterale Ausnehmungen (6), vorhanden sind, durch welche zumindest eine laterale Ausnehmung (6) jeweils ein Anschluss führbar ist, welcher die Elektrode (2) durchsetzt.

6. Elektrode nach Anspruch 4 oder 5, wobei die zumindest eine Öffnung (4) genau eine Öffnung (4) ist, in welcher bevorzugt ein Träger (7) für Bauelemente der Kabelmessvorrichtung (1) angeordnet oder anordenbar ist, oder wobei die zumindest eine Öffnung (4) eine Vielzahl von Öffnungen (4) ist, welche einen Gasaustausch zwischen einem Innenraum der Elektrode (2) und einem Außenraum der Elektrode (2) erlauben.

7. Kabelmessvorrichtung mit zumindest einer Elektrode (2), bevorzugt genau zwei Elektroden (2), nach einem der vorhergehenden Ansprüche.

8. Kabelmessvorrichtung nach Anspruch 7, wobei die Kabelmessvorrichtung (1)
- zum Durchführen einer Teilentladungsmessung eingerichtet ist, und/oder
- zum Durchführen einer Verlustfaktormessung, bevorzugt gleichzeitig mit der Teilentladungsmessung, eingerichtet ist.

9. Kabelmessvorrichtung nach einem der Ansprüche 7 oder 8, wobei im Innenraum der Elektrode (2) oder der Elektroden (2) zumindest eines der folgenden angeordnet ist:
- ein erster Anschluss (8) für ein zu vermessendes Kabel (9) und bevorzugt eine Kontaktelektrode zum leitenden Verbinden des ersten Anschlusses mit einer Elektrode (2) gemäß den Ansprüchen 1 bis 7
- ein zweiter Anschluss (11) für einen Ausgang eines Spannungsgenerators und/oder ein Strommessgerät (12)
- ein dritter Anschluss (13) für ein erstes Messgerät (14), bevorzugt ein Spannungsmessgerät
- zumindest ein Widerstandselement (15) zum leitenden Verbinden des ersten Anschlusses (8) mit dem zweiten Anschluss (11)
- eine Filterinduktivität (16)

10. Kabelmessvorrichtung nach einem der Ansprüche 7 bis 9, wobei die zumindest eine Elektrode (2) oder eine durch mehrere Elektroden (2) gebildete Elektrodenanordnung, bevorzugt über den Träger (7) gemäß Anspruch 7, über zumindest einen Kondensator (17) mit einem zweiten Messgerät (18), bevorzugt ein Ladungsmessgerät, leitend verbunden ist.

11. Kabelmessvorrichtung nach einem der Ansprüche 7 bis 10, wobei ein, vorzugsweise geerdetes oder erdbares, Gehäuse (19) vorhanden ist, worin die Elektrode (2) oder Elektroden (2) gemäß einem der Ansprüche 1 bis 7 angeordnet ist beziehungsweise sind.

12. Kabelmessvorrichtung nach einem der Ansprüche 7 bis 11, wobei eine Frequenzweiche (20) vorgesehen ist, über welche das zu vermessende Kabel (9) mit der Kabelmessvorrichtung (1) verbindbar ist.

13. Kabelmesswagen mit einer Kabelmessvorrichtung (1), bevorzugt nach einem der Ansprüche 7 bis 12, wobei die Kabelmessvorrichtung (1) zum Durchführen einer Kabelmessung, bevorzugt einer Teilentladungsmessung und/oder einer Verlustfaktormessung, in einem im Kabelmesswagen (10) montierten Zustand ausgebildet ist.

14. Verfahren zum Durchführen einer Kabelmessung, insbesondere einer Teilentladungsmessung und/oder einer Verlustfaktormessung, wobei das zu vermessende Kabel (9) mittelbar oder unmittelbar an eine Kabelmessvorrichtung (1) angeschlossen wird und die Kabelmessung durchgeführt wird, während die Kabelmessvorrichtung (1) in einem Kabelmesswagen montiert ist, vorzugsweise wobei das zu vermessende Kabel (9) über eine Frequenzweiche (20) an die Kabelmessvorrichtung (1) angeschlossen wird.

15. Verwendung einer Elektrode (2) nach einem der Ansprüche 1 bis 6 und/oder einer Kabelmessvorrichtung (1) nach einem der Ansprüche 7 bis 12 und/oder eines Kabelmesswagens (10) nach Anspruch 13 bei einem Verfahren nach Anspruch 14.
